# EUROPEAN PATENT APPLICATION

(11) **EP 4 546 980 A1**
(43) Date of publication of application: **30.04.2025**
(21) Application number: 24205819.6
(22) Date of filing: 10.10.2024
(51) Int. Cl.: H10F 39/00

(54) **IMAGE SENSOR AND ELECTRONIC APPARATUS INCLUDING THE IMAGE SENSOR**

(30) Priority: 24.10.2023 KR 20230143256
(71) Applicant: Samsung Electronics Co., Ltd., Suwon-si, Gyeonggi-do 16677 (KR)
(72) Inventor: Kim, Hyochul, 16678 Suwon-si, Gyeonggi-do (KR); Roh, Younggeun, 16678 Suwon-si, Gyeonggi-do (KR); Park, Kyungbae, 16678 Suwon-si, Gyeonggi-do (KR); Lim, Younhee, 16678 Suwon-si, Gyeonggi-do (KR); Yun, Sungyoung, 16678 Suwon-si, Gyeonggi-do (KR); Ahn, Sungmo, 16678 Suwon-si, Gyeonggi-do (KR)
(74) Representative: Grünecker Patent- und Rechtsanwälte PartG mbB

(57) **Abstract**

Am image sensor including a semiconductor substrate into which a plurality of photosensitive devices are integrated; a band filter array including a plurality of band filters, wherein each band filter of the plurality of band filters is configured to resonate light included in a specific wavelength band from among incident light, and to output the resonated light toward the semiconductor substrate; an active layer between the semiconductor substrate and the band filter array, and configured to generate excitons using the resonated light received from the band filter array; and an intermediate layer between the active layer and the semiconductor substrate, and configured to transmit at least one of the resonated light or the excitons to the semiconductor substrate.

## Description

### BACKGROUND

### 1. Field

The disclosure relates to an image sensor and an electronic apparatus including the same.

### 2. Description of Related Art

Image sensors may sense the color of incident light by using a color filter. In general, a color filter may refer to an absorption filter that selectively transmits light in only a specific wavelength band, and absorbs light in the remaining wavelength bands.

In ultra-high-resolution, ultra-small, high-sensitivity image sensors, which may include for example more than hundreds of millions of pixels, a band pass filter may be used. However, some band pass filters may a narrow bandwidth, and thus, there may a problem that the amount of light passing through the band pass filter is relatively small, and the signal-to-noise ratio (SNR) may be low.

### SUMMARY

The invention is what is claimed in the independent claims. Preferred embodiments are specified in the dependent claims.

Provided is an image sensor with a band filter that divides a wavelength band into more sections to improve color expression accuracy and object recognition performance, and an electronic apparatus including the image sensor.

Provided is an image sensor capable of improving the optical efficiency of a band filter with a narrow bandwidth and an electronic apparatus including the image sensor.

Additional aspects will be set forth in part in the description which follows and, in part, will be apparent from the description, or may be learned by practice of the presented embodiments of the disclosure.

In accordance with an aspect of the disclosure, an image sensor includes a semiconductor substrate into which a plurality of photosensitive devices are integrated; a band filter array including a plurality of band filters, wherein each band filter of the plurality of band filters is configured to resonate light included in a specific wavelength band from among incident light, and to output the resonated light toward the semiconductor substrate; an active layer between the semiconductor substrate and the band filter array, and configured to generate excitons using the resonated light received from the band filter array; and an intermediate layer between the active layer and the semiconductor substrate, and configured to transmit at least one of the resonated light or the excitons to the semiconductor substrate.

The active layer may include a singlet fission material.

The active layer may further include a metal porphyrin-based phosphorescent dopant.

An energy band gap of the metal porphyrin-based phosphorescent dopant may be greater than or equal to an energy band gap of a photosensitive device included in the image sensor.

The intermediate layer may include at least one of oxide, nitride, oxynitride, fluoride, or oxyfluoride.

A thickness of the active layer may be greater than a thickness of the intermediate layer.

The thickness of the active layer may be 5 times or more than the thickness of the intermediate layer.

A thickness of the active layer may be in a range of 50 nm or less.

A thickness of the intermediate layer may be in a range of 5 nm or less.

The band filter array may include: a first band filter configured to resonate first light included in a first wavelength band from among the incident light; and a second band filter configured to resonate second light included in a second wavelength band from among the incident light, the active layer may include a first active layer configured to overlap the first band filter in a thickness direction of the band filter array, and configured to generate the excitons using the resonated first light, and the active layer may further include a second active layer configured to overlap the second band filter in the thickness direction of the band filter array, and configured to generate the excitons using the resonated second light.

The image sensor may further include a barrier rib between the first active layer and the second active layer.

A refractive index of the barrier rib may be less than a refractive index of the first active layer and a refractive index of the second active layer.

A refractive index of the barrier rib may be in a range of 2 or less.

The band filter array may include: a third band filter configured to resonate third light included in a third wavelength band from among the incident light; and a fourth band filter configured to resonate fourth light included in a fourth wavelength band from among the incident light, and the fourth band filter and the active layer may not overlap in a thickness direction of the band filter array.

The image sensor may further include an anti-reflection layer configured to overlap the fourth band filter in the thickness direction of the band filter array.

The anti-reflection layer may include at least one of hafnium oxide, silicon oxide, aluminum oxide, or silicon nitride.

The image sensor may further include an anti-reflection layer between the band filter array and the active layer.

The band filter array may include a pigment that absorbs light in a wavelength band different from the specific wavelength band.

In accordance with an aspect of the disclosure, an electronic apparatus includes an image sensor configured to receive light reflected from an object, and to convert the light into an electrical signal; and a processor configured to generate an image corresponding to the object using the electrical signal received from the image sensor, wherein the image sensor may include: a semiconductor substrate into which a plurality of photosensitive devices are integrated; a band filter array including a plurality of band filters, wherein each band filter of the plurality of band filters is configured to resonate light included in a specific wavelength band from among incident light, and to output the resonated light toward the semiconductor substrate; an active layer between the semiconductor substrate and the band filter array, and configured to generate excitons using the resonated light received from the band filter array; and an intermediate layer between the active layer and the semiconductor substrate, and configured to transmit at least one of the resonated light and the excitons to the semiconductor substrate.

The image sensor may further include an anti-reflection layer disposed between the band filter array and the active layer.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic block diagram of an image sensor according to an embodiment;
FIG. 2 is a cross-sectional view schematically illustrating an image sensor according to an embodiment;
FIG. 3 is a reference diagram explaining a method performed by an image sensor of detecting light according to an embodiment;
FIG. 4 is a reference diagram illustrating quantum efficiency of an image sensor for each wavelength according to an embodiment;
FIG. 5 is a diagram illustrating an image sensor including a barrier rib according to an embodiment;
FIG. 6 is a diagram illustrating an image sensor including an anti-reflection layer according to an embodiment;
FIG. 7 is a diagram illustrating an image sensor including a barrier rib and an anti-reflection layer according to an embodiment.
FIG. 8 is a diagram illustrating an image sensor including an anti-reflection layer according to an embodiment;
FIGS. 9A to 9D are perspective views schematically illustrating structures of band filters according to embodiments;
FIGS. 10A and 10B are cross-sectional views schematically illustrating structures of band filters according to embodiments;
FIG. 11 is a diagram illustrating an image sensor including a color filter array according to an embodiment;
FIG. 12 is a diagram illustrating an image sensor including a band filter functioning as a color filter according to an embodiment;
FIG. 13 is a diagram illustrating an image sensor including a micro lens array according to an embodiment;
FIG. 14 is a diagram illustrating an image sensor including a single lens according to an embodiment;
FIG. 15 is a block diagram schematically illustrating an electronic apparatus including an image sensor according to an embodiment;
FIG. 16 is a block diagram schematically illustrating a camera module of FIG. 15, according to an embodiment;
FIGS. 17 to 26 are diagrams illustrating various examples of electronic apparatuses to which image sensors may be applied, according to embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments are described in detail with reference to the accompanying drawings. Like reference numerals in the drawings denote like elements, and the size of each element in the drawings may be exaggerated for clarity and convenience of description. Meanwhile, embodiments described below are merely examples, and various modifications may be made from these embodiments.

Hereinafter, what is described as "above" or "on" may include those directly on, underneath, left, and right in contact, as well as above, below, left, and right in non-contact. The singular forms are intended to include the plural forms as well, unless the context clearly indicates otherwise. Also, when the description specifies that a part "includes" any element, this means that the part may further include other elements, rather than excluding other elements, unless otherwise stated.

The term "the" and the similar indicative terms may be used in both the singular and the plural. If there is no explicit description of the order of steps included a method or no contrary description thereto, these steps may be performed in an appropriate order, and are not limited to the order described.

In addition, the terms "... unit", "module", etc. described herein mean a unit that processes at least one function or operation, may be implemented as hardware or software, or may be implemented as a combination of hardware and software.

Connections of lines or connection members between elements shown in the drawings are illustrative of functional connections and/or physical or circuitry connections, and may be replaced in an actual device, or may be represented as additional various functional connections, physical connections, or circuitry connections.

It will be understood that although the terms "first," "second," etc. may be used herein to describe various components, these components are not defined by the terms. These terms are only used to distinguish one component from another.

The use of all examples or example terms is merely for describing the technical concept in detail, and the scope thereof is not limited by these examples or example terms unless limited by claims.

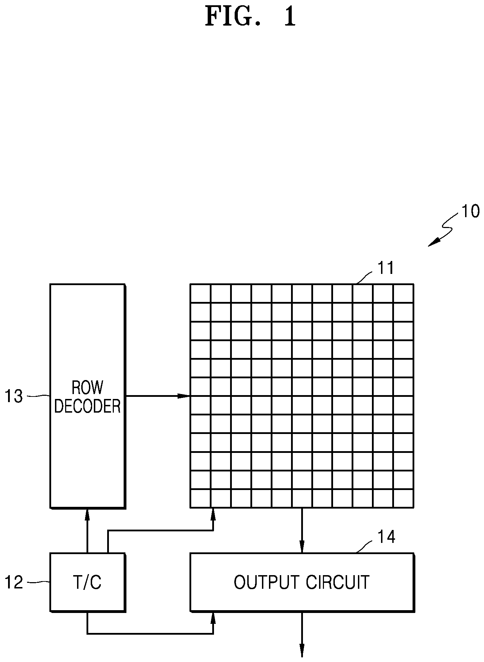

FIG. 1 is a schematic block diagram of an example of an image sensor 10 according to an embodiment. Referring to FIG. 1, the image sensor 10 may include a pixel array 11, a timing controller 12 (illustrated as "T/C"), a row decoder 13, and an output circuit 14. The image sensor 10 may include at least one of a charge-coupled device (CCD) image sensor and a complementary metal oxide semiconductor (CMOS) image sensor.

The pixel array 11 may include pixels that are two-dimensionally arranged in a plurality of rows and columns. The row decoder 13 may select one of the rows in the pixel array 11 based on, or in response to, a row address signal output from the timing controller 12. The output circuit 14 may output a photosensitive signal, in a column unit, from a plurality of pixels arranged in the selected row. In embodiments, the output circuit 14 may include a column decoder and an analog-to-digital converter (ADC) which may be used to output the photosensitive signal. For example, the output circuit 14 may include a plurality of ADCs that are arranged respectively to columns between the column decoder and the pixel array 11, or one ADC arranged at an output end of the column decoder. The timing controller 12, the row decoder 13, and the output circuit 14 may be implemented as one chip or separate chips. A processor for processing an image signal output from the output circuit 14 may be implemented as one chip along with the timing controller 12, the row decoder 13, and the output circuit 14, but embodiments are not limited thereto.

The pixel array 11 may include a plurality of pixels that may sense light having different wavelengths. An arrangement of pixels may be implemented in various ways. For example, the arrangement of pixels may include a blue pixel B, a green pixel G, a red pixel R, and a green pixel G arranged in one unit pattern. In some embodiments, the arrangement of pixels may include a magenta pixel M, a cyan pixel C, a yellow pixel Y, and a green pixel G arranged in one unit pattern.

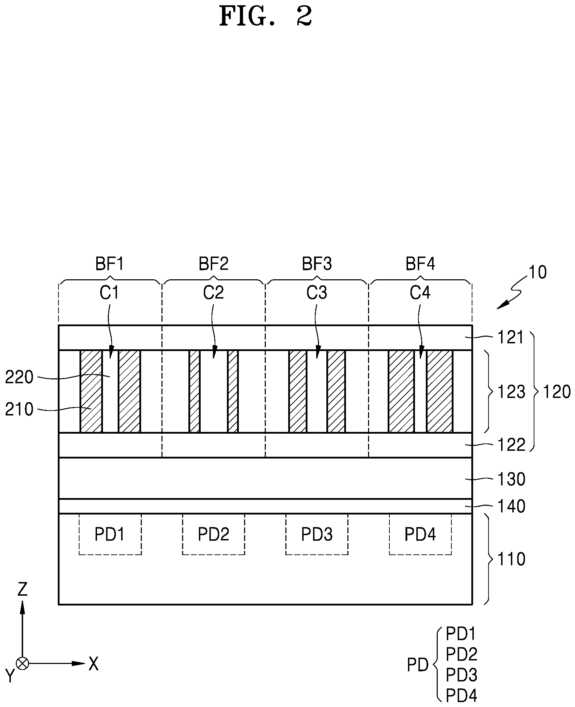

FIG. 2 is a cross-sectional view schematically illustrating an example of the image sensor 10, according to an embodiment. Referring to FIG. 2, the image sensor 10 may include a semiconductor substrate 110 into which a plurality of photosensitive devices PD are integrated.

The semiconductor substrate 110 may be a silicon substrate and may include the plurality of photosensitive devices PD that may convert light into electrical signals. For example, the semiconductor substrate 110 may include a first photosensitive device PD1, a second photosensitive device PD2, a third photosensitive device PD3, and a fourth photosensitive device PD4. The semiconductor substrate 110 may be integrated with a transfer transistor and a charge storage.

At least one of the first to fourth photosensitive devices PD1, PD2, PD3, and PD4 may be, or may include, a photodiode. The first to fourth photosensitive devices PD1, PD2, PD3, and PD4 may each include a p-n junction or a p-i-n junction. The first to fourth photosensitive devices PD1, PD2, PD3, and PD4 may each include an inorganic semiconductor selected from Si, Ge, GaAs, InP, GaN, AlN, CdTe, ZnTe, copper indium gallium (di)selenide (CIGS), and combinations thereof.

The first to fourth photosensitive devices PD1, PD2, PD3, and PD4, the transfer transistor and/or the charge storage may be integrated for each pixel, for example, the first to fourth photosensitive devices PD1, PD2, PD3, and PD4 may each be included in any one of the red pixel R, the green pixel G, the blue pixel B, and the red pixel R. The first to fourth photosensitive devices PD1, PD2, PD3, and PD4 may sense light, and sensed information corresponding to the sensed light may be transmitted by the transfer transistor.

A CMOS circuit may be disposed in a lower portion of the semiconductor substrate 110 and may include a transfer transistor and/or a charge storage.

The image sensor 10 according to an embodiment may include a band filter array 120 including a plurality of band filters BF1, BF2, BF3, and BF4 that resonate light of a specific wavelength in incident light and output the light toward the semiconductor substrate 110. The plurality of band filters BF1, BF2, BF3, and BF4 may correspond one-to-one to the first to fourth photosensitive devices PD1, PD2, PD3, and PD4. One band filter and one photosensitive device may correspond to one pixel. However, embodiments are not limited thereto. For example, in some embodiments, one photosensitive device may correspond to two or more band filters, and two or more photosensitive devices may correspond to one band filter. For convenience of explanation below, one pixel may be described as including one band filter BF and one photosensitive device.

The band filter array 120 may include a first band filter BF1 disposed on the first photosensitive device PD1, a second band filter BF2 disposed on the second photosensitive device PD2, a third band filter BF3 disposed on the third photosensitive device PD3, and a fourth band filter BF4 disposed on the fourth photosensitive device PD4. Neighboring band filters included in the band filter array 120 may be configured to resonate light having a center wavelength in different wavelength bands.

In embodiments, the band filter array 120 may include a first reflective layer 121 and a second reflective layer 122 spaced apart from each other, and a cavity 123 disposed between the first reflective layer 121 and the second reflective layer 122.

The first reflective layer 121 and the second reflective layer 122 may each have a flat mirror structure including a single material. For example, the first reflective layer 121 and the second reflective layer 122 may include at least one material selected from poly-silicon (poly-Si), gold (Au), copper (Cu), aluminum (Al), silver (Ag), tungsten (W), titanium (Ti), TiN, SiO2, TiO2, HfO2, Ta2O5, SiC, and SiN.

The cavity 123 may include a first cavity C1, a second cavity C2, a third cavity C3, and a fourth cavity C4 sequentially arranged in a direction (e.g., an X-axis direction) which is perpendicular to a thickness direction (e.g., a Z-axis direction) of the band filter array 120. The first cavity C1 may be included in the first band filter BF1, the second cavity C2 may be included in the second band filter BF2, the third cavity C3 may be included in the third band filter BF3, and the fourth cavity C4 may be included in the fourth band filter BF4.

Each of the first to fourth cavities C1, C2, C3, and C4 may include a plurality of dielectric materials 210 and 220 having different dielectric constants. For example, each of the first to fourth cavities C1, C2, C3, and C4 may include a first dielectric material 210 and a second dielectric material 220 arranged alternatingly in the thickness direction of the band filter BF. Here, the second dielectric material 220 may have a refractive index which is greater than a refractive index of the first dielectric material 210. As a specific example, the first dielectric material 210 may include silicon oxide, and the second dielectric material 220 may include titanium oxide. However, this is merely an example, and embodiments are not limited thereto.

Each of the first to fourth band filters BF1, BF2, BF3, and BF4 may have various types of dielectric material patterns according to a material, shape, size, and arrangement of each of the first and second dielectric materials 210 and 220. By changing the dielectric material pattern, an effective refractive index of each of the first to fourth band filters BF1, BF2, BF3, and BF4 may be adjusted. For example, as shown in FIG. 2, the effective refractive index may be adjusted by changing a ratio of volumes respectively occupied by the first and second dielectric materials 210 and 220 in the cavity 123. Each of the first to fourth band filters BF1, BF2, BF3, and BF4 may resonate and output light having a specific wavelength according to the material, pattern, and thickness of each of the first and second reflective layers 121 and 122, and the effective refractive index of the cavity 123.

The image sensor 10 may further include an active layer 130 disposed between the semiconductor substrate 110 and the band filter array 120 and generating excitons by light incident from the band filter array 120.

The active layer 130 may include a singlet fission material. The singlet fission material may generate a singlet exciton when a high-energy photon is absorbed by multiple exciton generation mechanism, and the singlet exciton may form two triplet excitons through singlet fission. Examples of of the active layer 130 and the multiple exciton generation mechanism are described below.

The image sensor 10 may further include an intermediate layer 140 disposed between the semiconductor substrate 110 and the active layer 130, which may transmit at least one of light or excitons to the semiconductor substrate 110. The intermediate layer 140 may include at least one of oxide, nitride, oxynitride, fluoride, or oxyfluoride.

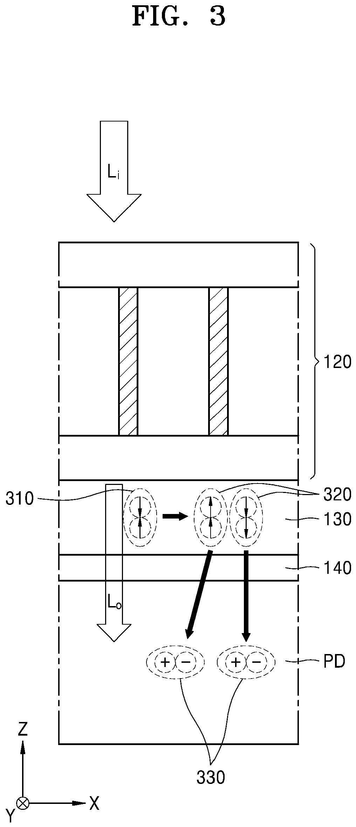

FIG. 3 is a reference diagram explaining a method performed by the image sensor 10 of detecting light according to an embodiment. Referring to FIG. 3, light Lᵢ may be incident on the band filter array 120. For example, the light Lᵢ in a visible light region (for example, having a wavelength in a wavelength region of approximately 400 nm to 700 nm) may be incident on the band filter array 120.

A band filter included in the band filter array 120 may resonate light Lₒ having a wavelength included in a specific wavelength band in the incident light Lᵢ and output the light Lₒ toward the active layer 130. In embodiments, the light having the wavelength included in the specific wavelength band may be referred to as light included in the specific wavelength band. Neighboring band filters may resonate and output light having different wavelengths. The light Lₒ corresponding to the specific wavelength band may be determined by an effective refractive index of the cavity 123, a thickness and material of each of the first and second reflectors 121 and 122, etc. For example, the light Lₒ corresponding to the specific wavelength band may be included in any one of red light corresponding to a wavelength band of about 600 nm to about 700 nm, green light corresponding to a wavelength band of about 500 nm to about 600 nm, and blue light corresponding to a wavelength band of about 400 nm to about 500 nm.

When the light Lₒ is incident on the active layer 130, a singlet fission material included in the active layer 130 may absorb at least part of the light Lₒ and generate a singlet exciton 310. The singlet exciton 310 may be split into two triplet excitons 320. The two triplet excitons 320 may be extracted as electron-hole pairs 330 after moving to the semiconductor substrate 110 through the intermediate layer 140. The active layer 130 may function as an organic photon conversion layer with a multi-exciton generation (MEG) effect. The active layer 130 may absorb photons and generate additional excitons, consequently enhancing the light transmission to the photosensitive devices PD.

As described above, the singlet fission material may increase the number of excitons by singlet fission, thereby increasing the photoelectric conversion efficiency of a photosensitive device located below and improving sensitivity of the image sensor 10.

The singlet fission material may be a single molecule, an oligomer, or a polymer, but embodiments are not limited thereto.

The singlet fission material may include acene, polyene, rylene, rubrene, quinoid compound, biradicaloid, derivatives thereof, or combinations thereof, but embodiments are not limited thereto.

The singlet fission material may have an absorption coefficient of about 1 X 103 cm-1 or more, for example, about 1.2 X 103 cm-1 or about 1.5 X 103 cm-1 or more, at one or more wavelengths in the visible light region (for example, having a wavelength in the wavelength range of about 400 nm to about 700 nm). The singlet fission material may have the absorption coefficient of about 1 X 104 cm-1 or less in the visible light region. The absorption coefficient may be obtained by coating a singlet fission material on a glass substrate by spin-coating to obtain a thin film, obtaining the absorbance of the thin film at the maximum absorption wavelength by using a UV-Vis-NIR spectrometer, dividing the absorbance by a thickness of the thin film.

The triplet energy of the singlet fission material may have an energy band gap of about 1.0 eV or more and about 4.0 eV or less, such as about 1.1 eV or more, about 1.2 eV or more, about 1.3 eV or more, about 1.4 eV or more, about 1.5 eV or more, about 1.6 eV or more, about 1.7 eV or more, about 1.8 eV or more, about 1.9 eV or more, or about 2.0 eV or more, and about 3.9 eV or less, about 3.8 eV or less, about 3.7 eV or less, about 3.6 eV or less, about 3.5 eV or less, about 3.4 eV or less, about 3.3 eV or less, about 3.2 eV or less, about 3.1 eV or less, or about 3.0 eV or less.

The energy band gap (of triplet energy) of the singlet fission material may be equal to or greater than the energy band gap of the inorganic semiconductor of each of the first to fourth photosensitive devices PD1, PD2, PD3, and PD4. For example, a difference Eg1-Eg3 between an energy band gap Eg1 of the singlet fission material and an energy band gap Eg3 of the inorganic semiconductor of the photosensitive device PD may be about 0.1 eV or more, for example, about 0.15 eV or more or about 0.2 eV or more. In the above range, diffusion and transfer of excitons generated from the singlet fission material may be effectively achieved.

The active layer 130 may include two or more different singlet fission materials, or may include a plurality of layers including different singlet fission materials. For example, the active layer 130 may include a first layer in direct or indirect contact with the intermediate layer 140 and a second layer on the first layer, and an energy band gap (of triplet energy) of the singlet fission material included in the second layer may be equal to or greater than an energy band gap (of triplet energy) of the singlet fission material included in the first layer. For example, a difference in the energy band gap between the first layer and the second layer may be about 0.1 eV or more, or about 0.2 eV or more.

The active layer 130 may further include a metal phophyrin-based phosphorescent dopant. The metal porphyrin-based phosphorescent dopant may emit light by receiving the energy of a triplet excitons from a singlet fission material, and the light energy may be received by an inorganic semiconductor of a photosensitive device and excited.

The metal porphyrin-based phosphorescent dopant may be included in an amount of about 0.1 to about 10 parts by weight based on 100 parts by weight of the singlet fission material. A metal of the metal porphyrin-based phosphorescent dopant may include at least one of Pt or Pd.

An energy band gap of the metal porphyrin-based phosphorescent dopant may be equal to or greater than the energy band gap of the inorganic semiconductor of each of the first to fourth photosensitive devices PD1, PD2, PD3, and PD4. For example, a difference Eg2-Eg3 between an energy band gap Eg2 of the metal porphyrin-based phosphorescent dopant and the energy band gap Eg3 of the inorganic semiconductor of the photosensitive device may be about 0.1 eV or more, for example, about 0.15 eV or more or about 0.2 eV or more. In the above range, diffusion and transfer of excitons generated from the singlet fission material may be effectively achieved.

A thickness of the active layer 130 may be less than a width of the pixel. Triplet excitons generated in the active layer 130 may move to the semiconductor substrate 110 included in the same pixel without moving to neighboring pixels. For example, the thickness of the active layer 130 may be about 50 nm or less, about 30 nm or less, or about 20 nm or less.

Triplet excitons generated from singlet fission material may diffuse into the intermediate layer 140. The intermediate layer 140 may prevent quenching of excitons and prevent extracted electrons and holes from recombining on a surface of the semiconductor substrate 110. The intermediate layer 140 may facilitate extraction of charges moving from the active layer 130 to the semiconductor substrate 110, thereby further reducing residual charges and exhibiting higher charge extraction efficiency. In addition, the intermediate layer 140 may serve as a passivation layer that protects the surface of the semiconductor substrate 110.

The intermediate layer 140 may include a dielectric material having a dielectric constant (which may be referred to as relative dielectric constant) of about 2 to about 150. The relative dielectric constant may refer to a ratio of a dielectric constant of another material to a dielectric constant of vacuum.

The dielectric material may have a dielectric constant of about 2.5 or more, about 3.0 or more, about 3.5 or more, about 4.0 or more, about 4.5 or more, about 5.0 or more, about 5.5 or more, about 6.0 or more, about 6.5 or more, about 7.0 or more, about 7.5 or more, and about 8.0 or more, and about 145 or less, about 140 or less, about 135 or less, about 130 or less, about 125 or less, about 120 or less, about 115 or less, about 110 or less, about 105 or less, and about 100 or less.

The intermediate layer 140 may include a plurality of layers. When the intermediate layer 140 includes the plurality of layers, the intermediate layer 140 may include dielectric materials having different dielectric constants.

The intermediate layer 140 may include an oxide including Si, Al, Sr, Ba, Mg, Ge, Ga, Ti, Zr, Ga, Hf, Ta, Nb, La, Y, Bi, Pb or a combination thereof, a nitride including Si, Al, Sr, Ba, Mg, Ge, Ga, Ti, Zr, Ga, Hf, Ta, Nb, La, Y, Bi, Pb or a combination thereof, an oxynitride including Si, Al, Sr, Ba, Mg, Ge, Ga, Ti, Zr, Ga, Hf, Ta, Nb, La, Y, Bi, Pb or a combination thereof, a fluoride including Si, Al, Sr, Ba, Mg, Ge, Ga, Ti, Zr, Ga, Hf, Ta, Nb, La, Y, Bi, Pb or a combination thereof, and an oxyfluoride including Si, Al, Sr, Ba, Mg, Ge, Ga, Ti, Zr, Ga, Hf, Ta, Nb, La, Y, Bi, Pb or a combination thereof. However, embodiments are not limited thereto.

A thickness of the intermediate layer 140 may be less than the thickness of the active layer 130. The thickness of the active layer 130 may be five times or more than the thickness of the intermediate layer 140. For example, the thickness of the intermediate layer 140 may be about 5 nm or less, about 3 nm or less, or about 1 nm or less. The intermediate layer 140 may facilitate the diffusion or transfer of triplet excitons to the semiconductor substrate 110, and may have a relatively small thickness. The active layer 130 and the intermediate layer 140 may be formed by atomic layer deposition (ALD).

As described above, the excitons generated in the active layer 130 may be transferred to the semiconductor substrate 110 through the intermediate layer 140, which may not need a separate electrode or circuit to transfer charges formed in the active layer 130, and thus, the image sensor 10 may be miniaturized and simplified.

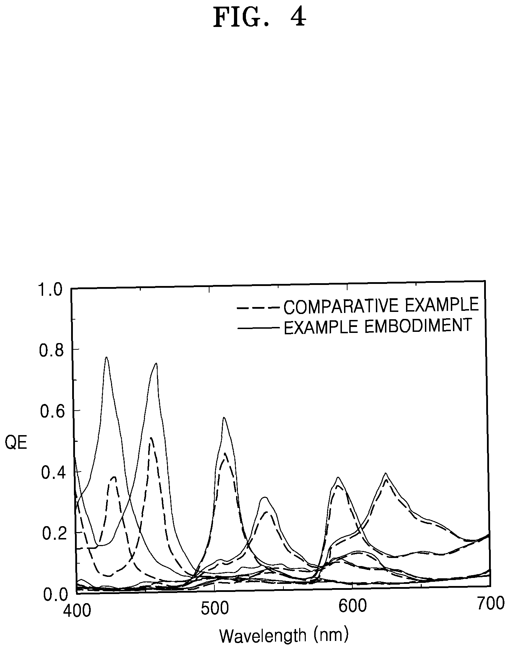

FIG. 4 is a reference diagram illustrating quantum efficiency (QE) of the image sensor 10 for each wavelength according to an example embodiment, in comparison with a comparative example. The image sensor 10 of the example embodiment illustrated in FIG. 4 may include the band filter array 120, the active layer 130, the intermediate layer 140, and the semiconductor substrate 110. In contrast, an image sensor of the comparative example illustrated in FIG. 4 does not include the active layer 130 and the intermediate layer 140, and may include the band filter array 120 and the semiconductor substrate 110. The band filter array 120 according to the example embodiment illustrated in FIG. 4 may be designed to resonate and output light of about 430 nm, about 460 nm, about 510 nm, about 540 nm, about 590 nm, and about 630 nm. The active layer 130 may include a single fissile material and has a thickness of about 30 nm, and the intermediate layer 140 may include HfO2 and has a thickness of about 1 nm. The QE may refer to a ratio of photons received by the semiconductor substrate 110 to the number of photons incident on the band filter array 120.

Referring to FIG. 4, it may be seen that the QE of the image sensor of the example embodiment illustrated in FIG. 4 including the active layer 130 and the intermediate layer 140 may be increased compared to the image sensor of the comparative example, which does not include the active layer 130 and the intermediate layer 140. For example, it may be confirmed that the QE of the image sensor 10 of the example embodiment illustrated in FIG. 4 may further increase with respect to shorter wavelength. For example, it may be confirmed that the QE with respect to light having a central wavelength of about 530 nm or less may be 0.5 or more.

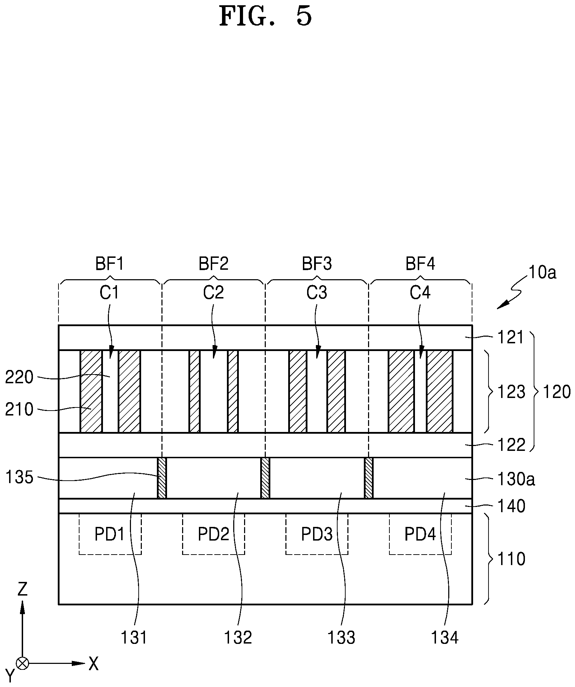

FIG. 5 is a diagram illustrating an image sensor 10a including a barrier rib 135 according to an embodiment. In comparison with the image sensor 10 illustrated in FIG. 2, an active layer 130a included in the image sensor 10a of FIG. 5 may be separated into pixel units by the barrier rib 135. For example, the active layer 130a may include a first active layer 131, a second active layer 132, a third active layer 133, and a fourth active layer 134, and the barrier ribs 135 may be disposed between neighboring active layers among the first to fourth active layers 131, 132, 133, and 134.

The barrier rib 135 may prevent light incident on an active layer of a specific pixel or exciton generated therein from moving to an active layer of another pixel. A refractive index of the barrier rib 135 may be less than a refractive index of each of the first to fourth active layers 131, 132, 133, and 134. The barrier rib 135 may include an insulating material having a refractive index of 2 or less. For example, the barrier rib 135 may include SiO2, SiN, Al2O3, or TiO2, but embodiments are not limited thereto.

Among the first to fourth active layers 131, 132, 133, and 134, light having different wavelengths may be incident on neighboring active layers, and the neighboring active layers may also include different materials that may better absorb the incident light and generate excitons.

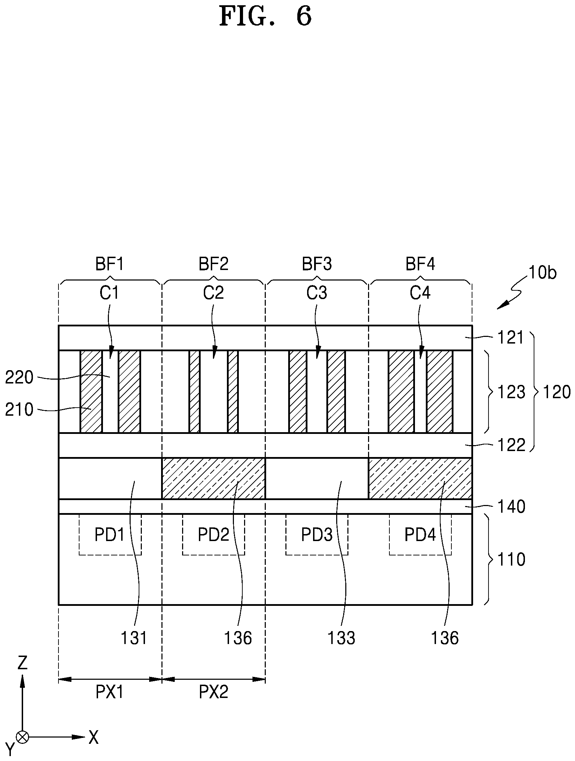

FIG. 6 is a diagram illustrating an image sensor 10b including an anti-reflection layer 136 according to an embodiment. In comparison with the image sensor 10 illustrated in FIG. 2, the image sensor 10b of FIG. 6 may include at least one pixel that includes an active layer, and at least one pixel that does not include an active layer. For example, a first pixel PX1 may include the first band filter BF1, a first active layer 131, the intermediate layer 140, and the first photosensitive device PD1, and a second pixel PX2 may include the second band filter BF2, the intermediate layer 140, and the second photosensitive device PD2.

The active layer 131 may have insufficient exciton generation with respect to light having a wavelength that is greater than or equal to a certain wavelength. For example, the active layer 131 may have insufficient exciton generation with respect to light having a wavelength that is greater than or equal to about 600 nm. Therefore, a pixel that may detect light of 600 nm or more may not include the active layer 131. In some embodiments, the image sensor 10b may include the anti-reflection layer 136 such that light output from a band filter may be incident on the second photosensitive device PD2 while minimizing reflection loss. For example, the image sensor 10b may further include the anti-reflection layer 136 disposed to overlap the second band filter BF2 in the thickness direction (e..g., the Z-axis direction) of the band filter array 120. The anti-reflection layer 136 may include at least one of hafnium oxide, silicon oxide, aluminum oxide, or silicon nitride.

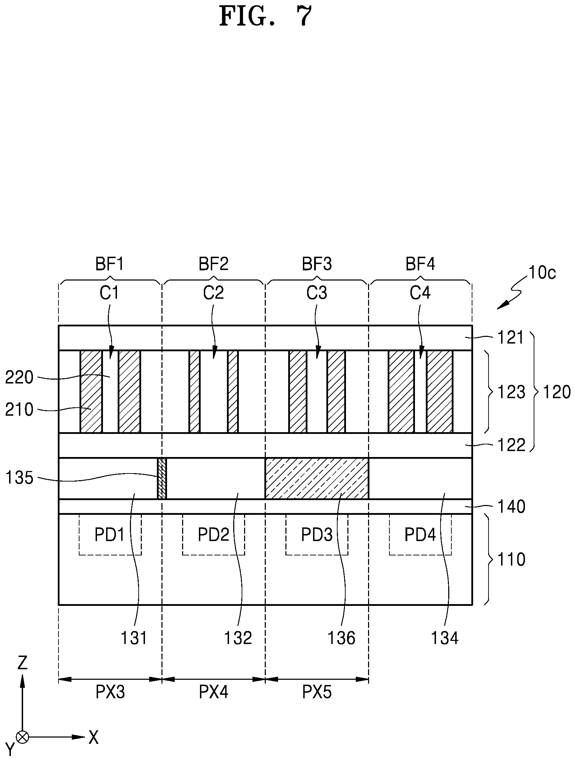

FIG. 7 is a diagram illustrating an image sensor 10c including the barrier rib 135 and the anti-reflection layer 136 according to an embodiment. In comparison with the image sensor 10 illustrated in FIG. 2, when neighboring pixels PX3 and PX4 respectively include active layers 131 and 132, the image sensor 10c of FIG. 7 may include the barrier rib 135 between the neighboring active layers 131 and 132. The pixel PX4 that includes no active layer may include the anti-reflection layer 136. Examples of the barrier rib 135 and the anti-reflection layer 136 have been described above, and thus, redundant or duplicative descriptions thereof with respect to FIG. 7 are omitted.

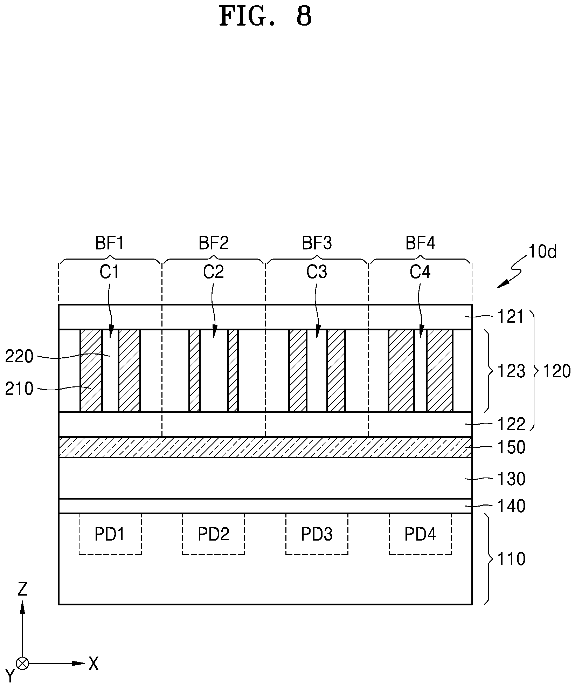

FIG. 8 is a diagram illustrating an image sensor 10d including an anti-reflection layer 150 according to an embodiment. In comparison with the image sensor 10 illustrated in FIG. 2, the image sensor 10d of FIG. 8 may further include an anti-reflection layer 150 between the band filter array 120 and the active layer 130. The anti-reflection layer 150 may transmit light incident from the band filter array 120 to the active layer 130 while minimizing reflection. The anti-reflection layer 150 may include at least one of hafnium oxide or silicon oxide.

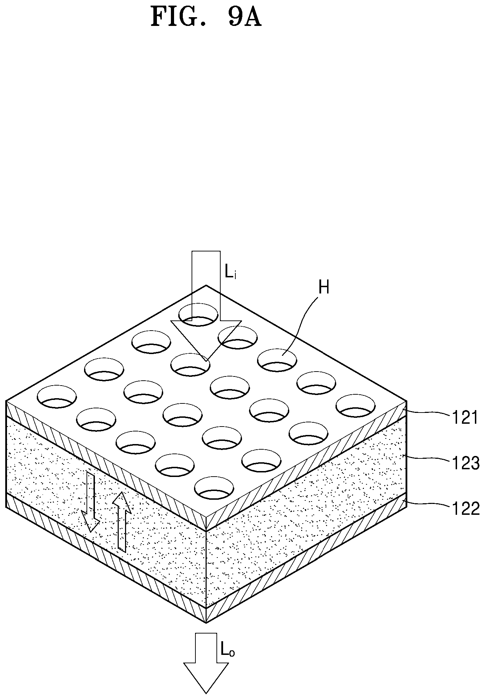

FIG. 2 shows that the first reflective layer 121 and the second reflective layer 122 of the band filter array 120 may each have a simple plane mirror structure with a flat surface, but the surface structure of each of the first reflective layer 121 and the second reflective layer 122 is not limited thereto. For example, FIGS. 9A to 9D are perspective views schematically illustrating structures of the band filter BF according to various embodiments.

Referring to FIG. 9A, the first reflective layer 121 and the second reflective layer 122 may each include a plurality of grooves H arranged periodically. For example, the plurality of grooves H may be arranged in a regular two-dimensional (2D) array. A pitch of each of the plurality of grooves H may be about 0.1 µm or more and about 10 µm or less. In embodiments, the pitch of the plurality of grooves H may refer to a distance between respective centers of adjacent grooves H, but embodiments are not limited thereto. A diameter of each of the plurality of grooves H may be about 0.2 times or more of the pitch, and about 0.8 times or less of the pitch. Each of the plurality of grooves H may be filled with a material different from a material of each of the first reflective layer 121 and the second reflective layer 122. The material filled inside of each of the plurality of grooves H may include a dielectric material having a relatively low refractive index. For example, a dielectric material having a refractive index of about 2.5 or less may be filled inside of each of the plurality of grooves H. For example, the dielectric material filled inside of each of the plurality of grooves H may include at least one of SiO2, SiN, Al2O3, or HfO2. In some embodiments, some or all of the inside of each of the plurality of grooves H may be empty. The plurality of grooves H may penetrate the first reflective layer 121 and the second reflective layer 122, or may not penetrate the first reflective layer 121 and the second reflective layer 122, and may be formed by partially etching the surface of each of the first reflective layer 121 and the second reflective layer 122. In the example of FIG. 9A, the shape of each of the plurality of grooves H is illustrated as being circular, but embodiments are not limited thereto. Each of the plurality of grooves H may have a circular, oval, or various polygonal shapes.

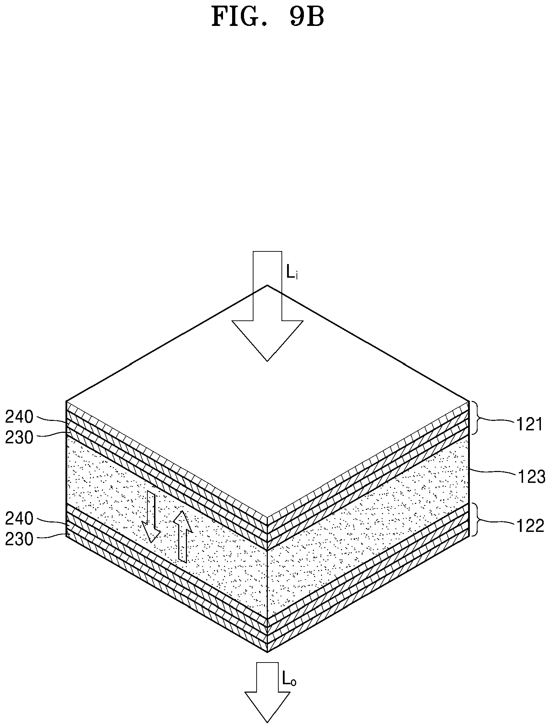

Referring to FIG. 9B, the first reflective layer 121 and the second reflective layer 122 may have a multilayer structure in which at least one first dielectric material layer 230 having a first refractive index is alternatingly stacked with at least one second dielectric material 240 having a second refractive index different from the first refractive index. For example, the first reflective layer 121 and the second reflective layer 122 may each be, or may each include, distributed Bragg reflectors (DBR). The thickness of each of the at least one first dielectric material layer 230 and the at least one second dielectric material 240 may be about 15 nm or more and about 250 nm or less.

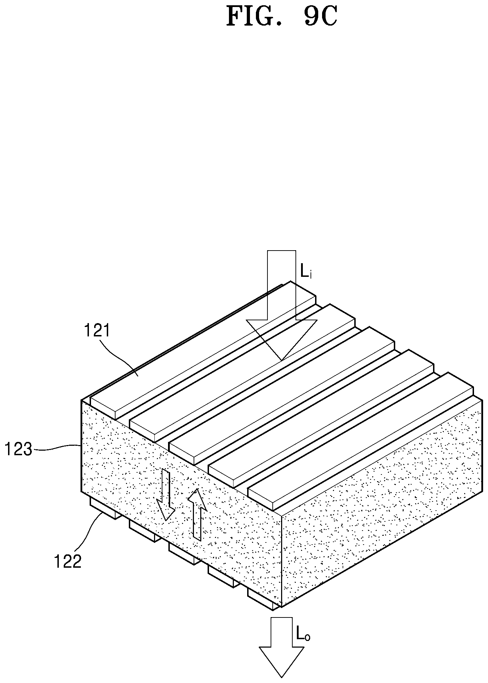

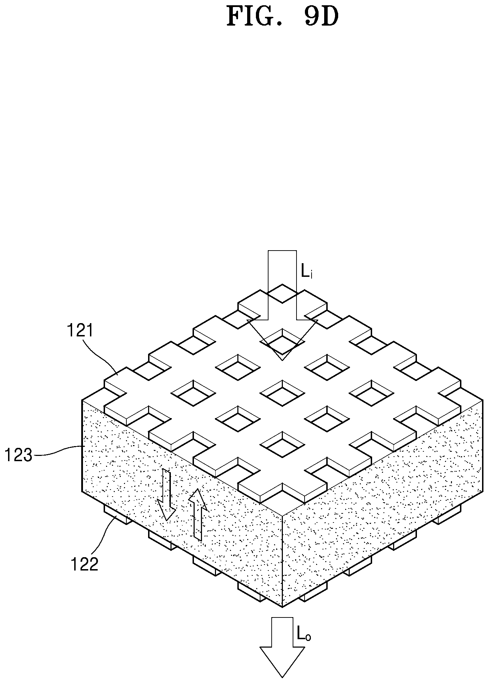

Referring to FIG. 9C, the first reflective layer 121 and the second reflective layer 122 may each include a plurality of grids that are periodically arranged in one dimension. Additionally, referring to FIG. 9D, the first reflective layer 121 and the second reflective layer 122 may each include a plurality of grids that are periodically arranged in two dimensions. The pitch of each of the plurality of grids may be about 0.1 µm or more and about 10 µm or less. The width of each of the plurality of grids may be about 0.1 times or more and about 0.9 times or less the pitch.

As shown in FIGS. 9A to 9D, the first reflective layer 121 and the second reflective layer 122 may have a one-dimensional or two-dimensional periodic structure. By adjusting a period of the periodic structure, a shape of the periodic structure, a thickness of the periodic structure, etc., the resonance wavelength of the band filter BF may be determined.

The examples of the band filter BF described above may have a vertical resonance structure. However, embodiments are not limited thereto. For example, in some embodiments, the band filter BF may have a horizontal resonance structure.

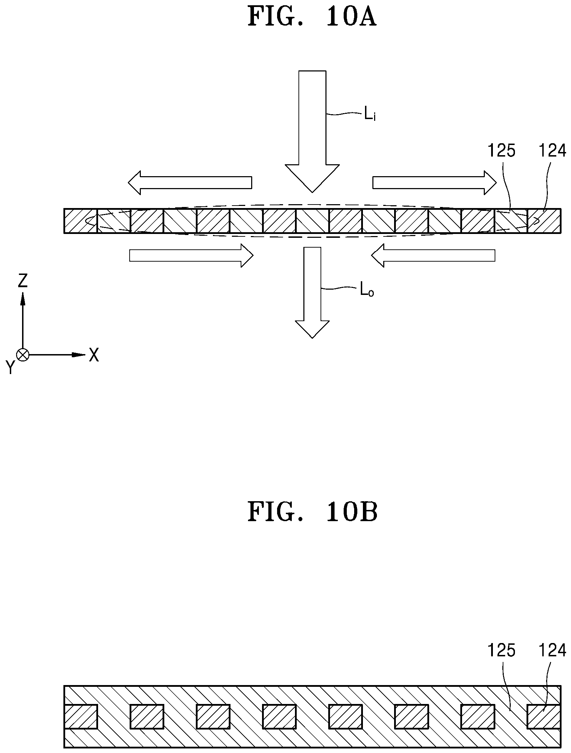

FIGS. 10A and 10B are cross-sectional views schematically illustrating structures of the band filter BF according to some embodiments.

Referring to FIG. 10A, the band filter BF may include a resonator including a plurality of nanostructures 124 arranged one-dimensionally or two-dimensionally on a plane parallel to a surface of the semiconductor substrate 110, and base layers 125 disposed between the plurality of nanostructures 124. A size of each of the plurality of nanostructures 124 may be smaller than a transmission wavelength of the band filter BF. For example, a cross-sectional width or diameter of each of the plurality of nanostructures 124 may be less than 400 nm, 300 nm, or 200 nm. Each of the plurality of nanostructures 124 may include a material having a greater refractive index than a refractive index of each of the base layers 125. The resonator including the plurality of nanostructures 124 may have, for example, a one-dimensional or two-dimensional periodic structure such as a photonic crystal, or a chirped structure in which a period gradually changes. In this case, light may resonate in a second direction (e.g., the X-axis direction) or a third direction (e.g., a Y-axis direction) perpendicular to the first direction (e.g., the Z-axis direction), that is, a horizontal direction. In this respect, the resonator may be a horizontal resonator that resonates horizontally.

The incident light Lᵢ may resonate in the second direction (e.g., the X-axis direction) or the third direction (e.g., the Y-axis direction) by the cavity 123, and the emitted light Lo after resonance may be incident toward the semiconductor substrate 110. The base layers 125 may be disposed to fill spaces between the plurality of nanostructures 124 of the resonator. Accordingly, while light resonates, light included in a wavelength band other than the transmission band may be absorbed by the base layers 125 while repeatedly passing through the base layers 125 .

Also, referring to FIG. 10B, the base layers 125 may be disposed to fill spaces between the plurality of nanostructures 124 of the resonator and completely cover lower and upper surfaces of the plurality of nanostructures 124. Accordingly, the plurality of nanostructures 124 of the resonator may be respectively buried inside the base layers 125.

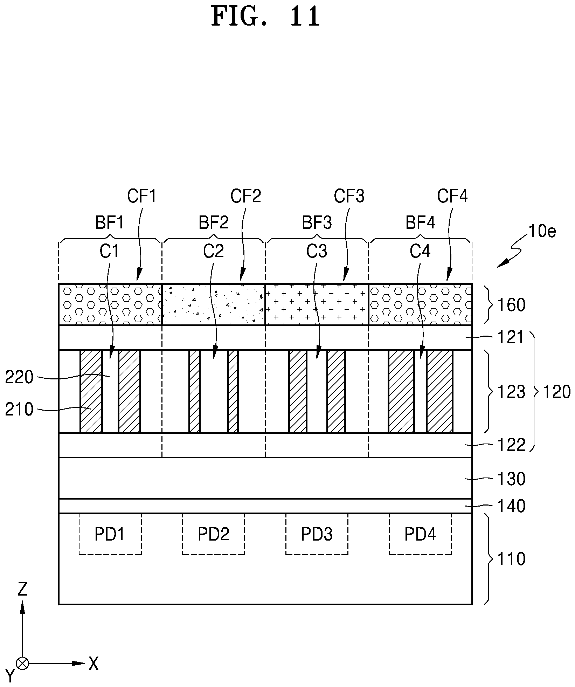

FIG. 11 is a diagram illustrating an image sensor 10e including a color filter array 160 according to an embodiment. In comparison with the image sensor 10 illustrated in FIG. 2, the image sensor 10e of FIG. 11 may further include the color filter array 160 disposed on an upper portion of the band filter array 120.

For example, the color filter array 160 may include a plurality of color filters CF1, CF2, CF3, and CF4. As shown in FIG. 11, a first color filter CF1 may be provided to correspond to the first band filter BF1, a second color filter CF2 may be provided to correspond to the second band filter BF2, a third color filter CF3 may be provided to correspond to the third band filter BF3, and a fourth color filter CF4 may be provided to correspond to the fourth band filter BF4. However, embodiments are not limited thereto. For example, in some embodiments, a color filter may be provided to correspond to two or more band filters.

Each of the first to fourth color filters CF1, CF2, CF3, and CF4 may allow the corresponding first to fourth band filters BF1, BF2, BF3, and BF4 to block light in an unwanted wavelength band, and transmit light in a desired wavelength band. For example, when the first band filter BF1 resonates light having a central wavelength in a wavelength band of approximately 400 nm to 500 nm, the first color filter CF1 may be a blue filter that transmits blue light. Additionally, when the second band filter BF2 resonates light having a central wavelength in a wavelength band of approximately 500 nm to 600 nm, the second color filter CF2 may be a green filter that transmits green light. Also, when the third band filter BF3 resonates light having a central wavelength in a wavelength band of approximately 600 nm to 700 nm, the third color filter CF3 may be a red filter that transmits red light.

Each of the first to fourth color filters CF1, CF2, CF3, and CF4 may include a pigment of a polymer substrate. For example, the green filter may include a first pigment that transmits light in a green wavelength band and absorbs light in other wavelength bands, the blue filter may include a second pigment that transmits light in a blue wavelength band and absorbs light in other wavelength bands, and the red filter may include a third pigment that transmits light in a red wavelength band and absorbs light in other wavelength bands.

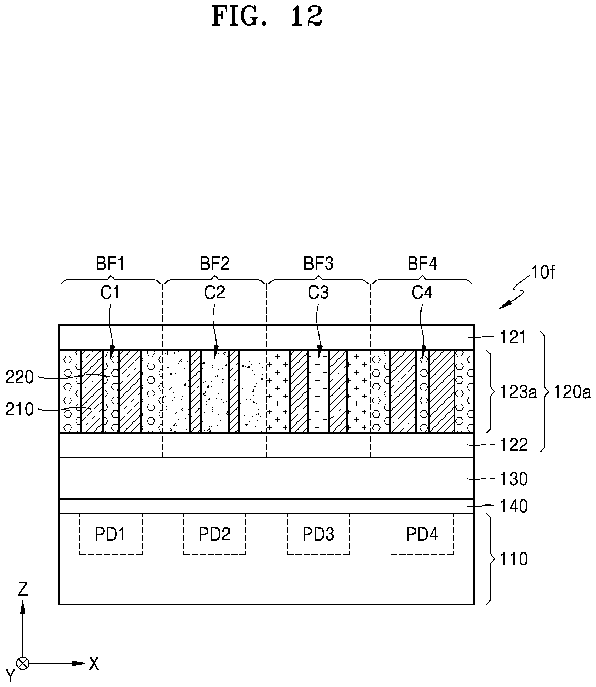

FIG. 12 is a diagram illustrating an image sensor 10f including a band filter 120a functioning as a color filter according to an embodiment. In comparison with the image sensor 10 illustrated in FIG. 2, a cavity 123a of each of the plurality of first to fourth band filters BF1, BF2, BF3, andBF4 of the image sensor 10f of FIG. 12 may be an absorption cavity. The absorption cavity 123a of each of the first to fourth band filters BF1, BF2, BF3, and BF4 may include a polymer-based pigment. For example, the absorption cavity 123a of each of the first band filter BF1 and the fourth band filter BF4 may include a first pigment that mainly transmits light (e.g., green light) in a first wavelength band and absorbs light (e.g., blue light and red light) in other wavelength bands. In addition, the absorption cavity 123a of the second band filter BF2 may include a second pigment that mainly transmits light (e.g., blue light) in a second wavelength band different from the first wavelength band and absorbs light (e.g., green light and red light) in other wavelength bands, and the absorption cavity 123a of the third band filter BF3 may include a third pigment that mainly transmits light (e.g., red light) in a third wavelength band and absorbs light (e.g., blue light and green light) in other wavelength bands.

Light included in a wavelength band other than the transmission band of the absorption cavity 123a while resonating in the first direction (e.g., the Z-axis direction) within the absorption cavity 123a is absorbed, and thus, a thickness of the band filter array 120a may be further reduced compared to the band filter array 120 of FIG. 2.

The thickness of the band filter array 120a may be relatively small, and thus, crosstalk may be reduced in the image sensor 10f, and the size of a photosensitive device of the image sensor may 10f be further reduced. Therefore, an ultra-high resolution image sensor may be easily manufactured.

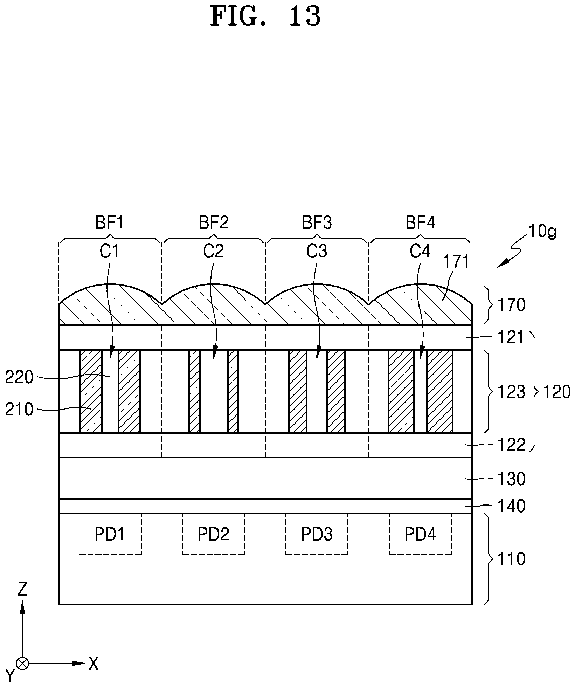

FIG. 13 is a diagram illustrating an image sensor 10g including a micro lens array 170 according to an embodiment. In comparison with the image sensor 10 illustrated in FIG. 2, the image sensor 10g may further include the micro lens array 170 disposed on the band filter array 120. Micro lenses 171 included in the micro lens array 170 may be arranged in one-to-one correspondence with the first to fourth band filters BF1, BF2, BF3, and BF4 included in the band filter array 120. However, embodiments are not limited thereto. The micro lenses 171 may be arranged to correspond to two or more band filters.

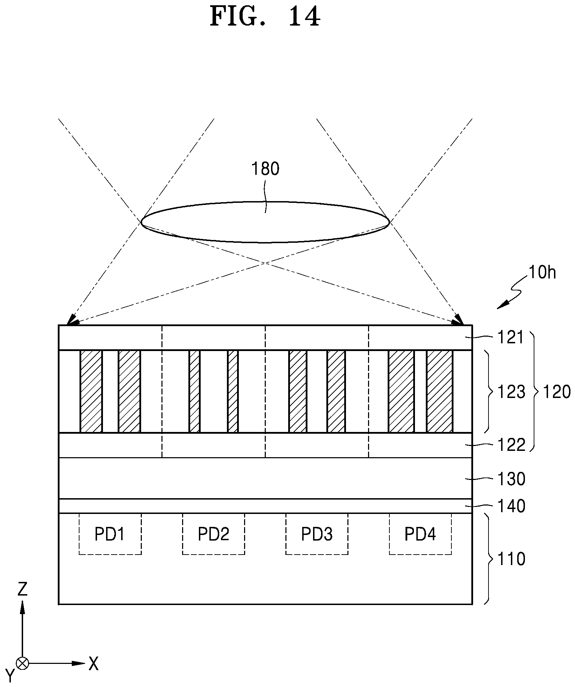

FIG. 14 is a diagram illustrating an image sensor 10h including a single lens 180 according to an embodiment. In comparison with the image sensor 10 illustrated in FIG. 2, the image sensor 10h may further include the single lens 180 on the band filter array 120. The image sensor 10h may be implemented as a simple optical system by providing the single lens 180 for forming an image of an object on an upper portion of the band filter array 120.

The image sensors 10e, 10f, 10g, and 10h of FIGS. 11, 13, and 14 are each illustrated as including the band filter array 120, the active layer 130, the intermediate layer 140, and the semiconductor substrate 110 shown in FIG. 2, but embodiments are not limited thereto. For example, in some embodiments, the image sensors 10e, 10f, 10g, and 10h of FIGS. 11, 13, and 14 may each further include at least one of the barrier rib 135 or the anti-reflection layers 136 and 150 shown in FIGS. 5 to 8.

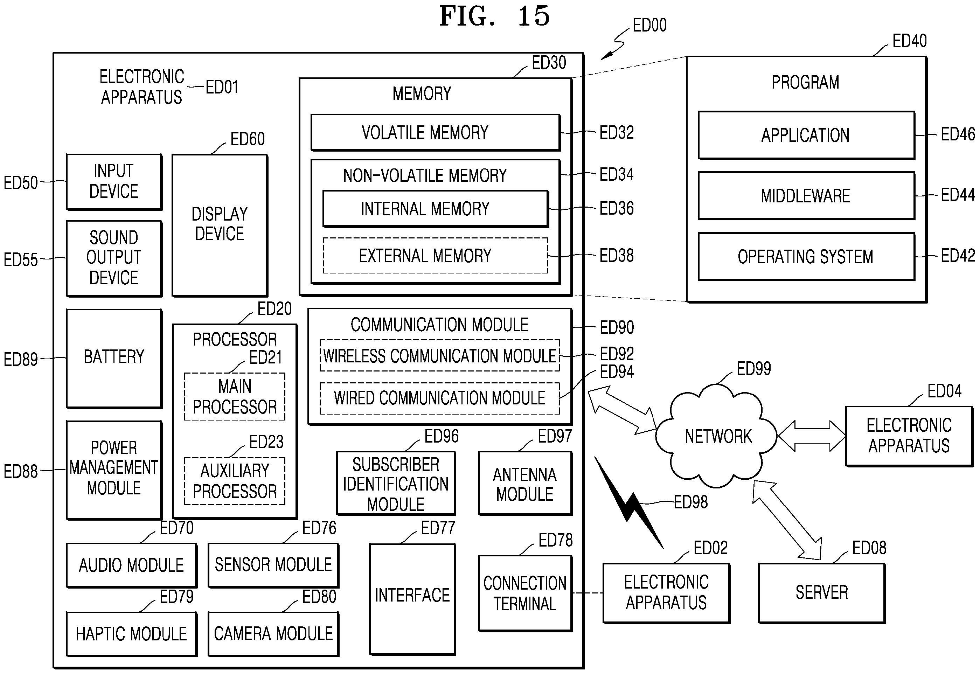

FIG. 15 is a block diagram of an example of an electronic apparatus ED01 including the image sensor 10. Referring to FIG. 15, in a network environment ED00, the electronic apparatus ED01 may communicate with another electronic apparatus ED02 via a first network ED98 (e.g., a short-range wireless communication network, etc.), or may communicate with another electronic apparatus ED04 and/or a server ED08 via a second network ED99 (e.g., a long-range wireless communication network, etc.) The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (e.g., the display device ED60, etc.) of the components may be omitted or another component may be added. Some of the components may be configured as one integrated circuit. For example, the sensor module ED76 (e.g., a fingerprint sensor, an iris sensor, an illuminance sensor, etc.) may be embedded and implemented in the display device ED60 (e.g., a display, etc.)

The processor ED20 may control one or more components (e.g., hardware, software components, etc.) of the electronic apparatus ED01 connected to the processor ED20 by executing software (e.g., a program ED40, etc.), and may perform various data processes or operations. As a part of the data processing or operations, the processor ED20 may load a command and/or data received from another component (e.g., the sensor module ED76, the communication module ED90, etc.) to a volatile memory ED32, may process the command and/or data stored in the volatile memory ED32, and may store result data in a non-volatile memory ED34. The processor ED20 may include a main processor ED21 (e.g., a central processing unit, an application processor, etc.) and an auxiliary processor ED23 (e.g., a graphic processing unit, an image signal processor, a sensor hub processor, a communication processor, etc.) that may be operated independently from or along with the main processor ED21. The auxiliary processor ED23 may use less power than that of the main processor ED21, and may perform specified functions.

The auxiliary processor ED23, on behalf of the main processor ED21 while the main processor ED21 is in an inactive state (e.g., a sleep state) or along with the main processor ED21 while the main processor ED21 is in an active state (e.g., an application executed state), may control functions and/or states related to some (e.g., the display device ED60, the sensor module ED76, the communication module ED90, etc.) of the components in the electronic apparatus ED01. The auxiliary processor ED23 (e.g., the image signal processor, the communication processor, etc.) may be implemented as a part of another component (e.g., the camera module ED80, the communication module ED90, etc.) that is functionally related thereto.

The memory ED30 may store various data required by the components (e.g., the processor ED20, the sensor module ED76, etc.) of the electronic apparatus ED01. The data may include, for example, input data and/or output data about software (e.g., the program ED40, etc.) and commands related thereto. The memory ED30 may include the volatile memory ED32 and/or the non-volatile memory ED34. The non-volatile memory ED34 may include an internal memory ED36 fixedly installed in the electronic apparatus ED01 and an external memory ED38 that is removable.

The program ED40 may be stored as software in the memory ED30, and may include an operation system ED42, middleware ED44, and/or an application ED46.

The input device ED50 may receive commands and/or data to be used in the components (e.g., the processor ED20, etc.) of the electronic apparatus ED01, from an outside (e.g., a user, etc.) of the electronic apparatus ED01. The input device ED50 may include a microphone, a mouse, a keyboard, and/or a digital pen (e.g., a stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include a touch circuitry set to sense a touch, and/or a sensor circuit (e.g., a pressure sensor, etc.) that is set to measure a strength of a force generated by the touch.

The audio module ED70 may convert sound into an electrical signal or vice versa. The audio module ED 70 may acquire sound through the input device ED50, or may output sound via the sound output device ED55 and/or a speaker and/or a headphone of another electronic apparatus (e.g., the electronic apparatus ED02, etc.) connected directly or wirelessly to the electronic apparatus ED01.

The sensor module ED76 may sense an operating state (e.g., power, temperature, etc.) of the electronic apparatus ED01, or an outer environmental state (e.g., a user state, etc.), and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED0 1 to be directly or wirelessly connected to another electronic apparatus (e.g., the electronic apparatus ED02, etc.) The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (e.g., the electronic apparatus ED02, etc.). The connection terminal ED78 may include an HDMI connector, a USB connector, an SD card connector, and/or an audio connector (headphone connector, etc.).

The haptic module ED79 may convert the electrical signal into a mechanical stimulation (e.g., vibration, motion, etc.) or an electric stimulation that the user may sense through a tactile or motion sensation. The haptic module ED79 may include a motor, a piezoelectric device, and/or an electric stimulus device.

The camera module ED80 may capture a still image and a video. The camera module ED80 may include a lens assembly including one or more lenses, the image sensor 10 of FIG. 1, image signal processors, and/or flashes. The lens assembly included in the camera module ED80 may collect light emitted from an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell.

The communication module ED90 may support the establishment of a direct (e.g., wired) communication channel and/or a wireless communication channel between the electronic apparatus ED01 and another electronic apparatus (e.g., the electronic apparatus ED02, the electronic apparatus ED04, the server ED08, etc.), and execution of communication through the established communication channel. The communication module ED90 may be operated independently from the processor ED20 (e.g., the application processor, etc.), and may include one or more communication processors that support the direct communication and/or the wireless communication. The communication module ED90 may include a wireless communication module ED92 (e.g., a cellular communication module, a short-range wireless communication module, a global navigation satellite system (GNSS) communication module) and/or a wired communication module ED94 (e.g., the local area network (LAN) communication module, a power line communication module, etc.). From among the communication modules, a corresponding communication module may communicate with another electronic apparatus via a first network ED09 (e.g., a short-range communication network such as Bluetooth, WiFi direct, or infrared data association (IrDA)) or a second network ED99 (e.g., a long-range communication network such as a cellular network, Internet, or computer network (LAN, WAN, etc.)). Such above various kinds of communication modules may be integrated as one component (e.g., a single chip, etc.) or may be implemented as a plurality of components (e.g., a plurality of chips) separately from one another. The wireless communication module ED92 may identify and authenticate the electronic apparatus ED01 in a communication network such as the first network ED98 and/or the second network ED99 by using subscriber information (e.g., an international mobile subscriber identifier (IMSI), etc.) stored in the subscriber identification module ED96.

The antenna module ED97 may transmit or receive the signal and/or power to/from outside (e.g., another electronic apparatus, etc.). An antenna may include a radiator formed as a conductive pattern formed on a substrate (e.g., a PCB, etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component (e.g., an RFIC, etc.) other than the antenna may be included as a part of the antenna module ED97.

Some of the components may be connected to one another via the communication method among the peripheral devices (e.g., a bus, a general purpose input and output (GPIO), a serial peripheral interface (SPI), a mobile industry processor interface (MIPI), etc.) and may exchange signals (e.g., a command, data, etc.).

The command or data may be transmitted or received between the electronic apparatus ED01 and the external electronic apparatus ED04 via the server ED08 connected to the second network ED99. Other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To do this, for example, a cloud computing, a distributed computing, or a client-server computing technique may be used.

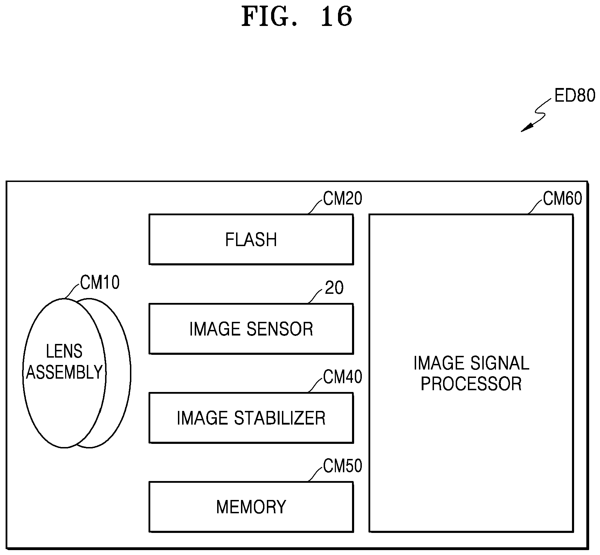

FIG. 16 is a block diagram of the camera module ED80 of FIG. 15. Referring to FIG. 16, the camera module ED80 may include a lens assembly CM10, a flash CM20, an image sensor 20 (e.g., the image sensor 10 of FIG. 2, etc.), an image stabilizer CM40, a memory CM50 (e.g., a buffer memory, etc.), and/or an image signal processor CM60. The lens assembly CM10 may collect light emitted from a subject for image capturing. The camera module ED80 may include a plurality of lens assemblies CM10, and in this case, the camera module ED80 may include a dual camera, a 360 degrees camera, or a spherical camera. Some of the lens assemblies CM10 may have the same lens attributes (e.g., a viewing angle, a focal length, auto focus, F Number, optical zoom, etc.), or different lens attributes. The lens assembly CM10 may include a wide angle lens or a telescopic lens.

The flash CM20 may emit light used to reinforce light emitted or reflected from an object. The flash CM20 may include one or a plurality of light-emitting diodes (e.g., a red-green-blue (RGB) LED, a white LED, an infrared LED, an ultraviolet LED, etc.), and/or a xenon lamp. The image sensor 20 may include the image sensor described with reference to FIGS. 1 to 3, 5 to 8, and 11 to 14, and may convert light emitted or reflected from the subject and transmitted through the lens assembly CM10 into electrical signals, thereby obtaining an image corresponding to the subject. The image sensor 20 may include one or a plurality of sensors selected from the image sensors 20 having different attributes such as an RGB sensor, a black and white (BW) sensor, an IR sensor, or UV sensor. Each sensor included in the image sensor 20 may be implemented by a charged coupled device (CCD) sensor and/or a complementary metal oxide semiconductor (CMOS) sensor.

Based on, or in response to, a motion of the camera module ED80 or the electronic apparatus ED01 including the camera module ED80, the image stabilizer CM40 may move one or more lenses included in the lens assembly CM10 or the image sensor 20 in a certain direction or controls the operating characteristics of the image sensor 20 (e.g., adjusting of a read-out timing, etc.) in order to compensate for a negative influence of the motion. The image stabilizer CM40 may sense the movement of the camera module ED80 or the electronic apparatus ED01 by using at least one of a gyro sensor and an acceleration sensor arranged in or out of the camera module ED80. The image stabilizer CM40 may be implemented as an optical type.

The memory CM50 may store a part or entire data of an image obtained through the image sensor 20 for a subsequent image processing operation. For example, when a plurality of images are obtained at high speed, only low resolution images are displayed while the obtained original data (Bayer-Patterned data, high resolution data, etc.) is stored in the memory CM50. Then, the memory CM50 may be used to transmit the original data of a selected (e.g., user selection, etc.) image to the image signal processor CM60. The memory CM50 may be incorporated into the memory ED30 of the electronic apparatus ED01, or configured to be an independently operated separate memory.

The image signal processor CM60 may perform image processing on the image obtained through the image sensor 20 or the image data stored in the memory CM50. The image processing may include depth map generation, three-dimensional modeling, panorama generation, feature point extraction, image synthesis, and/or image compensation (e.g., noise reduction, resolution adjustment, brightness adjustment, blurring, sharpening, softening, etc.) The image signal processor CM60 may perform control (e.g., exposure time control, read-out timing control, etc.) on elements (e.g., the image sensor 20, etc.) included in the camera module ED80. The image processed by the image signal processor CM60 may be stored again in the memory CM50 for additional processing or provided to external elements (e.g., the memory ED30, the display device ED60, the electronic apparatus ED02, the electronic apparatus ED04, the server ED08, etc.) of the camera module ED80. The image signal processor CM60 may be incorporated into the processor ED20, or configured to be a separate processor operated independently of the processor ED20. When the image signal processor CM60 is configured by a separate processor from the processor ED20, the image processed by the image signal processor CM60 may undergo additional image processing by the processor ED20 and then displayed through the display device ED60.

The electronic apparatus ED01 may include a plurality of camera modules ED80 having different attributes or functions. In this case, one of the camera modules ED80 may be a wide angle camera, and another may be a telescopic camera. Similarly, one of the camera modules ED80 may be a front side camera, and another may be a read side camera.

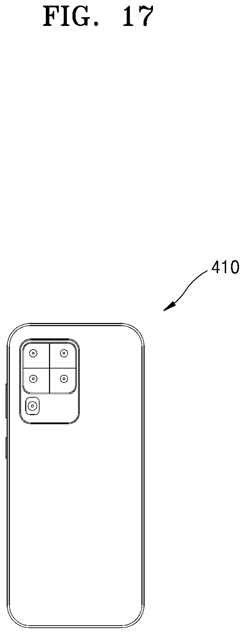

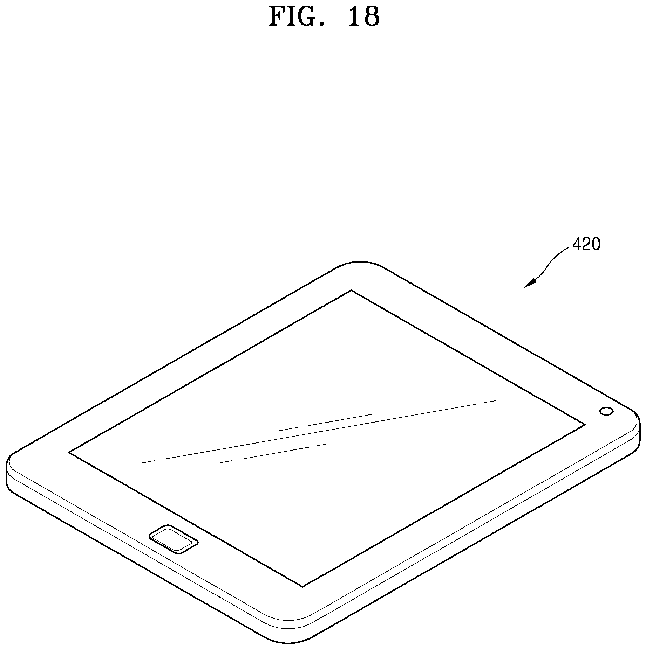

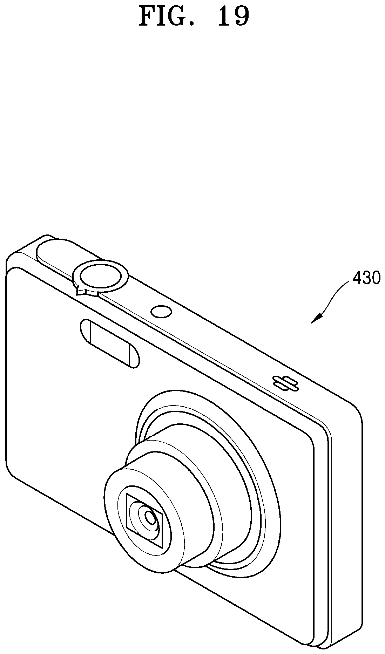

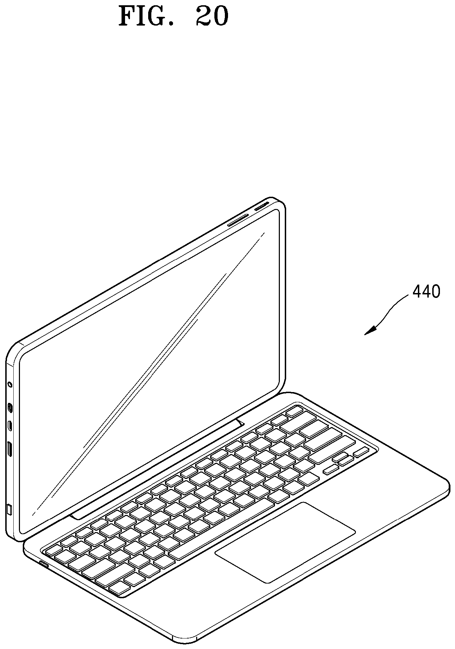

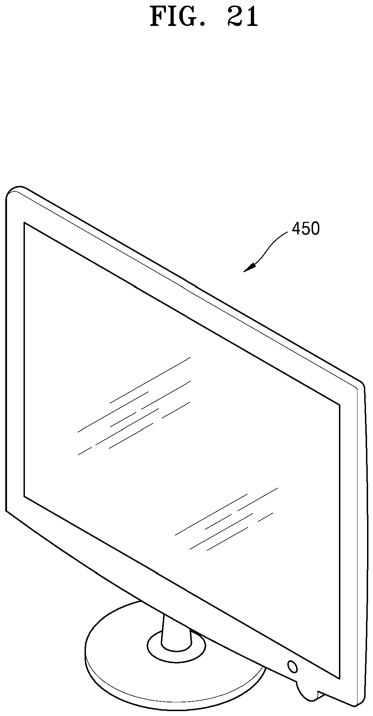

The image sensor 20 according to some embodiments may be applied to a mobile phone or smartphone 410 illustrated in FIG. 17, a tablet or smart tablet 420 illustrated in FIG. 18, a digital camera or camcorder 430 illustrated in FIG. 19, a notebook computer 440 illustrated in FIG. 20, a television or smart television 450 illustrated in FIG. 21, etc. For example, the smartphone 410 or the smart tablet 420 may include a plurality of high resolution cameras, each having the high resolution image sensor 20 mounted thereon. Depth information of subjects in an image may be extracted by using high resolution cameras, out focusing of the image may be adjusted, or objects in the image may be automatically identified.

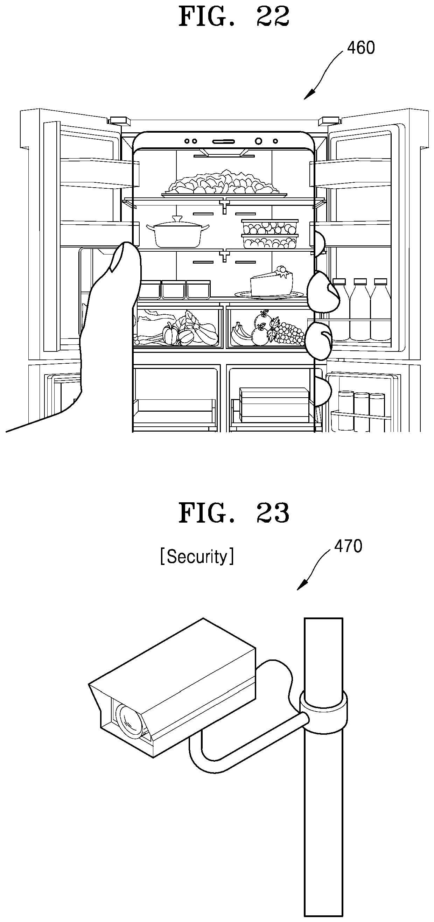

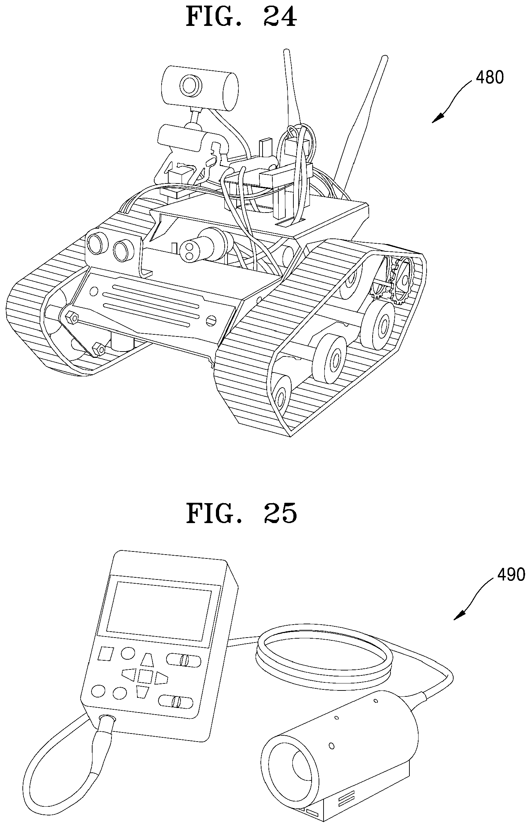

Furthermore, the image sensor 20 may be applied to a smart refrigerator 460 illustrated in FIG. 22, a security camera 470 illustrated in FIG. 23, a robot 480 illustrated in FIG. 24, a medical camera 490 illustrated in FIG. 25, etc. For example, the smart refrigerator 460 may automatically recognize food in a refrigerator, by using the image sensor 20, and notify a user of the presence of a particular food, the type of food that is input or output, and the like, through a smartphone. The security camera 470 may provide an ultrahigh resolution image and may recognize an object or a person in an image in a dark environment by using high sensitivity. The robot 480 may be provided in a disaster or industrial site that is not directly accessible by people, and may provide a high resolution image. The medical camera 490 may provide a high resolution image for diagnosis or surgery, and thus a field of vision may be dynamically adjusted.

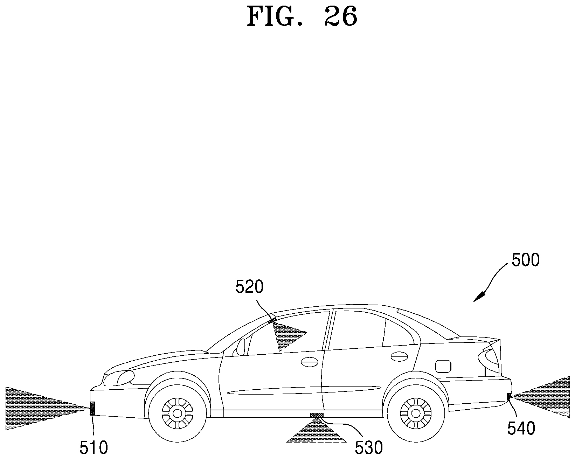

Furthermore, the image sensor 20 may be applied to a vehicle 500 as illustrated in FIG. 26. The vehicle 500 may include a plurality of vehicle cameras 510, 520, 530, and 540 arranged at various positions. Each of the vehicle cameras 510, 520, 530, and 540 may include an image sensor according to an embodiment. The vehicle 500 may provide a driver with various pieces of information about the inside or periphery of the vehicle 500, by using the vehicle cameras 510, 520, 530, and 540, thereby providing an object or a person in an image may be automatically recognized and information needed for autonomous driving.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An image sensor comprising:
a semiconductor substrate into which a plurality of photosensitive devices are integrated;
a band filter array comprising a plurality of band filters, wherein each band filter of the plurality of band filters is configured to resonate light included in a specific wavelength band from among incident light, and to output the resonated light toward the semiconductor substrate;
an active layer between the semiconductor substrate and the band filter array, and configured to generate excitons using the resonated light received from the band filter array; and
an intermediate layer between the active layer and the semiconductor substrate, and configured to transmit at least one of the resonated light or the excitons to the semiconductor substrate.

2. The image sensor of claim 1, wherein the active layer comprises a singlet fission material.

3. The image sensor of claim 1 or 2, wherein the active layer further comprises a metal porphyrin-based phosphorescent dopant.

4. The image sensor of claim 3, wherein an energy band gap of the metal porphyrin-based phosphorescent dopant is greater than or equal to an energy band gap of a photosensitive device included in the image sensor.

5. The image sensor of one of claims 1 to 4, wherein the intermediate layer comprises at least one of oxide, nitride, oxynitride, fluoride, or oxyfluoride.

6. The image sensor of one of claims 1 to 5, wherein a thickness of the active layer is greater than a thickness of the intermediate layer, or
wherein a thickness of the active layer is 5 times or more than a thickness of the intermediate layer, or
wherein a thickness of the active layer is in a range of 50 nm or less.

7. The image sensor of one of claims 1 to 6, wherein a thickness of the intermediate layer is in a range of 5 nm or less.

8. The image sensor of one of claims 1 to 7,
wherein the band filter array comprises:
a first band filter configured to resonate first light included in a first wavelength band from among the incident light; and
a second band filter configured to resonate second light included in a second wavelength band from among the incident light,
wherein the active layer comprises a first active layer configured to overlap the first band filter in a thickness direction of the band filter array, and configured to generate the excitons using the resonated first light, and
wherein the active layer further comprises a second active layer configured to overlap the second band filter in the thickness direction of the band filter array, and configured to generate the excitons using the resonated second light.

9. The image sensor of claim 8, further comprising a barrier rib between the first active layer and the second active layer.

10. The image sensor of claim 9, wherein a refractive index of the barrier rib is less than a refractive index of the first active layer and a refractive index of the second active layer, or
wherein a refractive index of the barrier rib is in a range of 2 or less.

11. The image sensor of one of claims 1 to 10, wherein the band filter array comprises:
a third band filter configured to resonate third light included in a third wavelength band from among the incident light; and
a fourth band filter configured to resonate fourth light included in a fourth wavelength band from among the incident light, and
wherein the fourth band filter and the active layer do not overlap in a thickness direction of the band filter array.

12. The image sensor of claim 11, further comprising an anti-reflection layer configured to overlap the fourth band filter in the thickness direction of the band filter array, and
wherein the anti-reflection layer comprises at least one of hafnium oxide, silicon oxide, aluminum oxide, or silicon nitride.

13. The image sensor of one of claims 1 to 12, further comprising an anti-reflection layer between the band filter array and the active layer.

14. The image sensor of one of claims 1 to 13, wherein the band filter array comprises a pigment that absorbs light in a wavelength band different from the specific wavelength band.

15. An electronic apparatus comprising:
an image sensor configured to receive light reflected from an object, and to convert the light into an electrical signal; and
a processor configured to generate an image corresponding to the object using the electrical signal received from the image sensor,
wherein the image sensor comprises:
a semiconductor substrate into which a plurality of photosensitive devices are integrated;
a band filter array comprising a plurality of band filters, wherein each band filter of the plurality of band filters is configured to resonate light included in a specific wavelength band from among incident light, and to output the resonated light toward the semiconductor substrate;
an active layer between the semiconductor substrate and the band filter array, and configured to generate excitons using the resonated light received from the band filter array; and
an intermediate layer between the active layer and the semiconductor substrate, and configured to transmit at least one of the resonated light and the excitons to the semiconductor substrate.
